# FASCICULE DE BREVET EUROPEEN

(11) **EP 2 771 661 B1**
(45) Date de publication et mention de la délivrance du brevet: **20.02.2019**
(21) Numéro de dépôt: 12778331.4
(22) Date de dépôt: 24.10.2012
(51) Int. Cl.: B81B 3/00, G01L 9/00, G01L 19/06

(54) **STRUCTURE MICROMÉCANIQUE A MEMBRANE DÉFORMABLE ET A PROTECTION CONTRE DE FORTES DÉFORMATIONS**
MIKROMECHANISCHE STRUKTUR MIT EINER VERFORMBAREN MEMBRAN UND EINEM SCHUTZ VOR STARKEN VERFORMUNGEN
MICROMECHANICAL STRUCTURE HAVING A DEFORMABLE MEMBRANE AND A PROTECTION AGAINST STRONG DEFORMATIONS

(30) Priorité: 26.10.2011 FR 1159726
(43) Date de publication de la demande: 03.09.2014
(73) Titulaire: Auxitrol SA, 18000 Bourges (FR)
(72) Inventeur: BRIDA, Sebastiano, F-11410 Salles sur l'Hers (FR)
(74) Mandataire: Regimbeau
(86) Numéro de dépôt international: PCT/EP2012/071000
(87) Numéro de publication internationale: WO 2013/060697

(56) Documents cités:
- FR-A1- 2 859 281
- JP-A- S59 155 971
- JP-A- S62 145 130
- US-A- 5 062 302

## Description

### DOMAINE TECHNIQUE GENERAL

L'invention concerne une structure micromécanique destinée à mesurer ou à détecter une grandeur mécanique ou une grandeur dynamique.

Et elle concerne plus particulièrement une structure micromécanique pour la mesure absolue, relative ou différentielle d'une pression.

### ETAT DE LA TECHNIQUE

Une structure micromécanique pour mesurer une grandeur mécanique ou dynamique telle qu'une pression comprend classiquement une membrane déformable et un substrat support, la membrane étant suspendue au-dessus du substrat support définissant ainsi un espace libre.

Des utilisations de ces membranes suspendues sont connues (cf. par exemple les structures micromécaniques divulguées dans les documents US-5062302-A, FR-2859281-A1, JP-S62145130-A et JP-S59155971-A).

Ainsi, des capteurs capacitifs ou des jauges de contrainte supportés par la membrane peuvent mesurer les déformations que subit la membrane soumise à un apport d'énergie externe (telle que par exemple une pression appliquée perpendiculairement au plan principal de la membrane), en observant les modifications de propriétés physiques de la membrane associés aux déformations (telles que par exemple un changement de capacité électrique ou de contraintes internes).

De cette façon on peut mesurer par exemple les modifications d'énergie apportée à la membrane ou de force exercée sur la membrane et donc surveiller des grandeurs physiques dans un certain milieu (que ce soient des grandeurs de type dynamique, c'est à dire de type accélération ou de type décélération, et/ou de type mécanique).

De telles membranes soumises à de fortes énergies peuvent devenir fragiles, leurs propriétés intrinsèques pouvant être altérées, et leur structure pouvant se fissurer voire se rompre.

### PRESENTATION DE L'INVENTION

L'invention permet de pallier au moins l'un des inconvénients précités.
A cet effet l'invention propose une structure micromécanique selon la revendication 1.

L'invention est avantageusement complétée par les caractéristiques suivantes, prises seules ou en une quelconque de leur combinaison techniquement possible :
- les ilots comportent des facettes inclinées qui sont orientées selon des angles aigus supérieurs à zéro degré par rapport à la surface plane de la butée inférieure ;
- les ilots sont en forme de mésa ;
- Elle comprend en outre une butée supérieure disposée au-dessus de la membrane ;
- la butée supérieure comprend des évidements répartis autour de son centre ;
- la base support et la butée inférieure sont respectivement formées dans deux matériaux différents l'un de l'autre ;
- le substrat support est en verre et dans laquelle la butée inférieure et ledit substrat support en verre sont connectés par scellement anodique ou au moyen d'une liaison moléculaire ou covalente avec ou sans couche intermédiaire, ou par frittage ou par brasage ;
- la base support et la butée inférieure sont formées dans un seul et même matériau ;
- la base support et les butées sont chacune en un matériau choisi parmi les matériaux suivants : alliages ; verre ; quartz ; alumine ; céramique ; Si ; SiC ; saphir ;
- la partie fine de la membrane présente une épaisseur comprise entre 20 µm et 100 µm ;
- les ilots présentent une hauteur comprise entre 10 µm et 50 µm et une largeur maximale comprise entre 20 µm et 200 µm.

En outre, l'invention propose un capteur de pression différentielle comprenant une structure micromécanique selon le premier aspect de l'invention.

Les avantages de l'invention sont multiples.

La butée inférieure permet de protéger la membrane des surpressions.

Le fait de prévoir une butée comme élément indépendant pour la résistance aux surpressions permet de rajouter cette dernière à toutes les structures micromécanique déjà existantes, sans aucun changement dimensionnel de la membrane déformable et sans aucune modification du comportement mécanique ou thermique de la structure.

Ainsi, la résistance de la structure micromécanique est accrue sans modifier ni la structure ni la géométrie de la membrane suspendue. De plus, elle ne modifie ni la structure ni la définition des éléments de mesure montés sur la membrane et n'encombre pas la partie exposée de la membrane.

Par ailleurs, les ilots permettent de minimiser les contraintes dues à la dilatation thermique de l'huile ou d'un autre fluide (liquide ou gazeux) présent dans l'espace entre la membrane et la butée. Ces ilots permettent en outre une bonne circulation du fluide et permettent d'améliorer le remplissage de la structure dans le cas d'une utilisation comme capteur de pression différentielle. Ceci est très important dans le cas d'un fluide visqueux, les ilots permettant d'éviter l'apparition de bulles d'air dans le fluide, et réduisant ainsi les erreurs qui pourraient être dues à une mauvaise circulation du fluide, une fois que la structure est remplie dudit fluide, dans le cas d'une utilisation comme capteur de pression différentielle par exemple.

La structure micromécanique atteint donc une résistance aux contraintes externes sans avoir à modifier pour cela la membrane suspendue, cette structure micromécanique pouvant ainsi fonctionner par exemple avec des membranes standard.

### PRESENTATION DES FIGURES

D'autres caractéristiques et avantages de l'invention ressortiront encore de la description qui suit laquelle est purement illustrative et non limitative et doit être lue en regard des dessins annexés sur lesquels
- la figure 1 illustre une structure micromécanique selon un mode de réalisation de l'invention ;
- la figure 2 illustre une structure micromécanique selon un mode de réalisation de l'invention ;

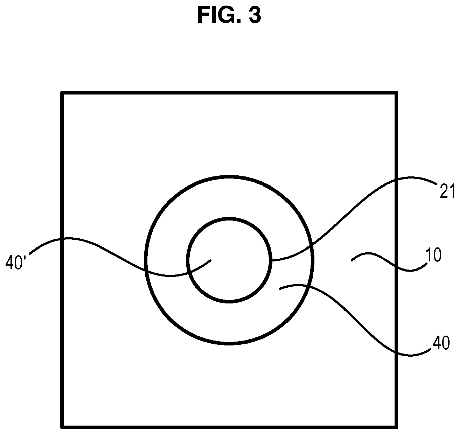

- la figure 3 illustre une vue de dessous de la structure micromécanique de l'invention ;
- la figure 4 illustre un capteur différentiel de pression comprenant une structure micromécanique selon l'invention ;
- la figure 5 illustre une vue détaillée d'une partie de la structure micromécanique de l'invention ;
- les figures 6a et 6b illustrent deux vues de la butée inférieure de la structure micromécanique de l'invention.

Sur l'ensemble des figures, les éléments similaires portent des références numériques identiques.

### DESCRIPTION DETAILLEE DE L'INVENTION

Une structure micromécanique destinée à mesurer ou à détecter une grandeur mécanique ou une grandeur dynamique telle qu'une pression comprend une membrane 20 déformable et un substrat support 10.

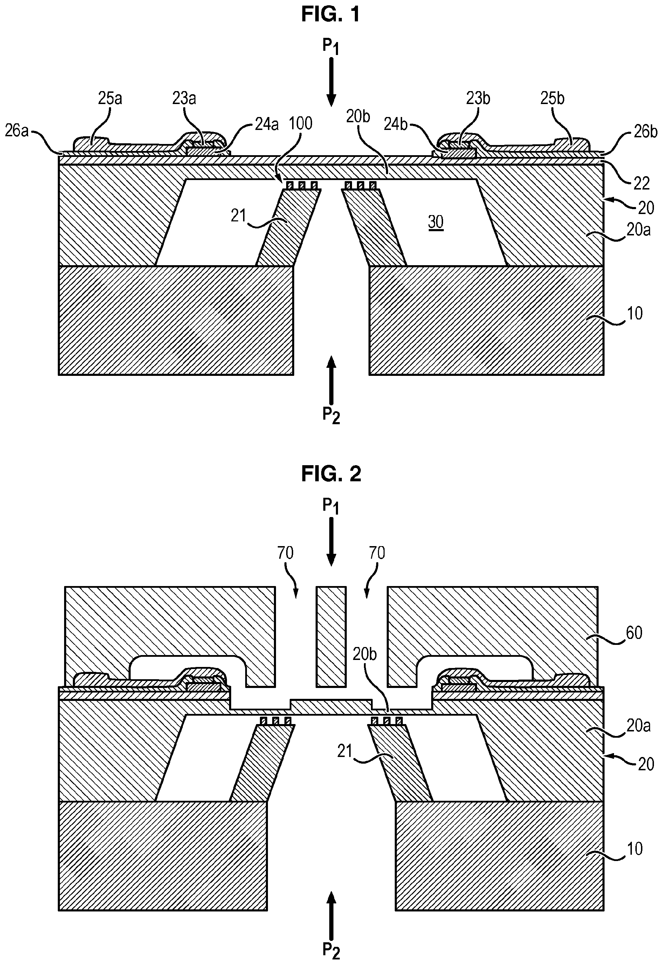

Comme cela est visible sur les figures 1, 2 et 4, la membrane est disposée au-dessus du substrat support 10 pour définir un espace libre 30. Cette espace libre 30 est destiné à être rempli par un fluide dans le cas d'une structure micromécanique pour une mesure différentielle de la pression. Dans ce cas une pression P1 provient du dessus de la structure et une pression P2 provient du dessous de la structure (voir les figures 1, 2 et 4).

La membrane 20 est destinée à supporter des éléments de mesure de pression 22, 23a, 23b, 24a, 24b, 25a, 25b, 26a, 26b.

L'espace libre 30 est généralement formé par micro-usinage dans un substrat initial. Les techniques de micro-usinage pour former un tel espace libre peuvent par exemple être de la gravure chimique telle qu'une gravure KOH à une température déterminée.

De manière complémentaire, la membrane est constituée de deux parties distinctes : une première partie 20a qui présente une épaisseur supérieure à une seconde partie 20b fine qui sert d'élément actif. La seconde partie 20b est entourée par la première partie 20a. La partie 20a est celle qui est en contact avec le substrat support 10 tandis que la partie fine 20b est suspendue au-dessus de l'espace libre 30.

La seconde partie 20b de la membrane 20 présente une épaisseur inférieure à l'épaisseur de la première partie 20a de la membrane.

L'épaisseur de la partie 20b fine est typiquement comprise entre 20 et 100 µm, la valeur étant définie selon la plage de la grandeur mécanique ou dynamique à mesurer.

De cette façon, la membrane 20, notamment sa partie fine 20b, peut se déformer sous l'effet d'une pression P1 appliquée sur cette dernière.

Le substrat support 10 peut être un matériau à base de verre, de Silicium quartz, pyrex™, saphir, alumine, Si, SiC.

L'épaisseur du substrat support 10 est typiquement comprise entre 500 µm et 2000 µm.

La membrane 20 est connectée au substrat support 10 par scellement anodique ou au moyen d'une liaison moléculaire ou atomique avec ou sans couche intermédiaire, ou par frittage ou par brasage.

La membrane 20 est typiquement formée à partir d'un substrat par exemple constitué de Silicium monocristallin comme le SOI (en anglais, *« Silicon On Insulator* ») et le PSOI (en anglais, *« Poly Silicon On Insulator* »), de saphir comme le SOS (en anglais, « *Silicon On Saphir* »), ou d'un autre matériau comme le SiCOI (en anglais, « *SiC on Insulator* ») ou le SiC.

La membrane 20 comporte une couche électriquement isolante 22 telle qu'une couche SiO2 dans le cas d'une membrane 20 en SOI ou PSOI, déposée sur sa surface externe opposée à l'espace libre 30. Sur cette couche isolante 22, différents matériaux tels que des nitrures, des oxydes, des couches métalliques, du Silicium mono et polycristallin, sont disposés de manière à former les microstructures 23a, 23b, 24a, 24b, 25a, 25b, 26a, 26b. Les micro-structures peuvent ainsi former des jauges de contraintes et servir d'éléments de mesure de la grandeur physique à mesurer par exemple une pression.

Pour assurer les connexions, des zones de contacts électriques 25a, 25b sont en outre disposées sur la membrane 20. Ces zones de contacts électriques 25a, 25b sont par exemple constituées d'Aluminium, d'or, de platine, de titane, de Tungstène.

Pour protéger la membrane 20 contre des déformations, en cas de surpression provenant du dessus de la structure, la structure micromécanique comprend une butée inférieure 21 limitant les déformations de la membrane 20. La butée inférieure 21 est disposée au-dessus du substrat support 10 et s'étend dans l'espace libre 30 à partir du substrat support 10 vers la membrane 20.

La butée inférieure 21 est de préférence constituée dans un matériau identique à celui de la membrane 20 ou en alliages, du saphir, de l'alumine, de la céramique, du quartz ou du verre. Elle peut de même être constituée dans un matériau identique à celui du substrat support 10.

La buté inférieure 21 est de forme générale trapézoïdale, la grande base étant disposée sur le substrat 10 support et la petite base est disposée directement en dessous de la membrane 20 en particulier sous sa partie 20b fine, cette petite base définie une surface plane de la butée 21 inférieure.

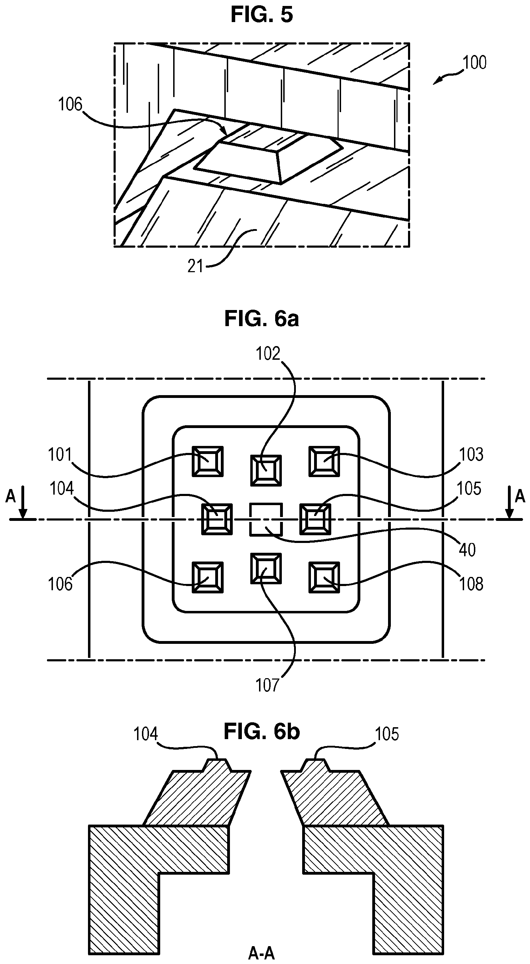

Pour augmenter l'efficacité de la butée inférieure 21 celle-ci comprend (voir sur les figures 5 et 6a et 6b), sur une surface plane, définie notamment par la petite base de la butée inférieure, des ilots 101, 102, 103, 104, 105, 106, 107, 108 qui s'étendent à partir d'une surface plane de la butée inférieure 21, la surface plane correspondant à la base des ilots.

Les ilots 101-108 forment ainsi une structure en relief de sorte qu'en cas de contact entre les ilots 101-108 et la partie fine 20b de la membrane 20, la surface de contact entre les ilots 101-108 et la partie fine 20b de la membrane 20 est faible par rapport aux dimensions de la partie fine 20b de la membrane 20.

Les ilots 101-108 comportent avantageusement des facettes inclinées qui sont orientées selon des angles aigus supérieurs à zéro degré par rapport à la surface plane de la butée inférieure. Ils sont notamment en forme de mésa.

Les ilots ainsi formés permettent une circulation optimale du fluide dans l'espace entre la membrane 20 et la butée inférieure 21.

Un autre avantage est que les ilots permettent également de minimiser les erreurs dues à la variation de densité du fluide (en cas de variation de températures au cours de l'utilisation de la structure micromécanique par exemple de -50°C à 180 °C) dans l'espace situé entre la butée 21 inférieure et la membrane 20.

Les ilots ont une hauteur comprise préférentiellement entre 10µm et 50µm, et une largeur à la base comprise entre 20µm et 200µm.

Par ailleurs, les ilots sont dimensionnés pour que la partie fine de la membrane et les ilots soient espacés d'une distance comprise entre 5 et 30 µm, de préférence 10 µm.

Les ilots sont par exemple obtenus par un procédé de micro-usinage comprenant des étapes de photolithographie et de gravure appliqué sur la face supérieure de la butée inférieure 21. Le type de gravure appliquée permet de définir la forme des ilots (forme mésa pour une gravure humide anisotrope type gravure KOH, TMAH forme à pans verticaux pour une gravure sèche type RIE (en anglais, « *Reactive Ion Etching* »))*.*

De manière préférée, la butée inférieure comprenant les ilots est obtenue à partir d'un substrat en silicium dans lequel on forme par gravure les ilots et l'évidement (voir ci-après). Les zones de pré-formation des ilots sont protégées par un masque de préférence en SiO₂ + Si₃N₄, un second masque SiO₂ + Si3N₄ étant réalisé après la liaison de la butée inférieure 21 au substrat support 10, la liaison étant de préférence obtenue par un scellement anodique, le substrat support 10 étant alors en verre.

Comme mentionné ci-dessus, il existe un écart entre la butée 21 inférieure et la membrane 20. Cet écart représente la distance maximale de déformation de la membrane 20. De cette manière, une déformation plus importante que cet écart met alors la membrane 20 en appui contre la butée 21 ce qui empêche une surdéformation liée à une surpression. C'est en particulier contre les ilots que la membrane 20 vient en appui dans le cas d'une surpression P1 provenant du haut de la structure.

De manière avantageuse, la valeur de cet écart peut être choisie en fonction des paramètres de résistance à la déformation de la membrane 20 (dépendant notamment de son épaisseur et du matériau qui la constitue) avec un écart seuil à partir duquel la membrane risque de se détériorer.

De cette façon, il est possible d'ajuster les paramètres de la butée inférieure 21 en fonction de l'application visée.

Pour la mesure différentielle de la pression, le substrat support 10 comprend donc un évidement 40 traversant qui se prolonge selon un évidement 40' dans la butée 21 inférieure. Les évidements 40, 40' du substrat support 10 et de la butée 21 inférieure sont de préférence circulaires.

L'évidement 40' de la butée peut être de diamètre identique ou inférieur au diamètre de l'évidement du substrat support 10. Toutefois cette option ne fait pas partie de l'invention revendiquée. Selon l'invention l'évidement 40' de la butée est en forme de cône tel que le grand diamètre du cône soit du côté du substrat 10 support et se réduit au fur et à mesure que l'évidement progresse dans l'épaisseur de la butée 21 inférieure.

On note que sans évidement 40, la structure micromécanique permet une mesure absolue de la pression. Toutefois cette option ne fait pas partie de l'invention revendiquée.

L'évidement 40 présente une forme géométrique permettant l'accès de la pression par le substrat support 10. L'évidement 40 peut prendre la forme d'un cylindre simple de diamètre généralement compris entre 500 µm et 1500 µm, ou d'une forme plus complexe comme par exemple un cylindre double dont le diamètre de la partie supérieure sera inférieur à celui du cylindre simple.

Les évidements 40, 40' du substrat support 10 et de la butée 21 inférieure permettent le passage de fluides (gaz ou liquides) et sont donc nécessaires dans le cas d'un capteur différentiel ou relatif pour permettre le transfert de la pression P2 à la partie inférieure de la membrane 20.

Les évidements 40, 40' dans le substrat support 10 de la butée inférieure 21 sont effectués par gravure grâce à une solution alcaline de gravure anisotrope (KOH, TMAH, ...), réalisée de préférence en deux étapes : une première étape de pré-gravure, puis une gravure finale après la liaison de la butée inférieure 21 au substrat support 10, la liaison étant de préférence obtenue par un scellement anodique, le substrat support 10 étant alors en verre. A noter que les zones à épargner par la gravure sont protégées par un procédé de photolithographie 3D de type connu à base de résine épaisse (épaisseur comprise entre 10µm et 50µm).

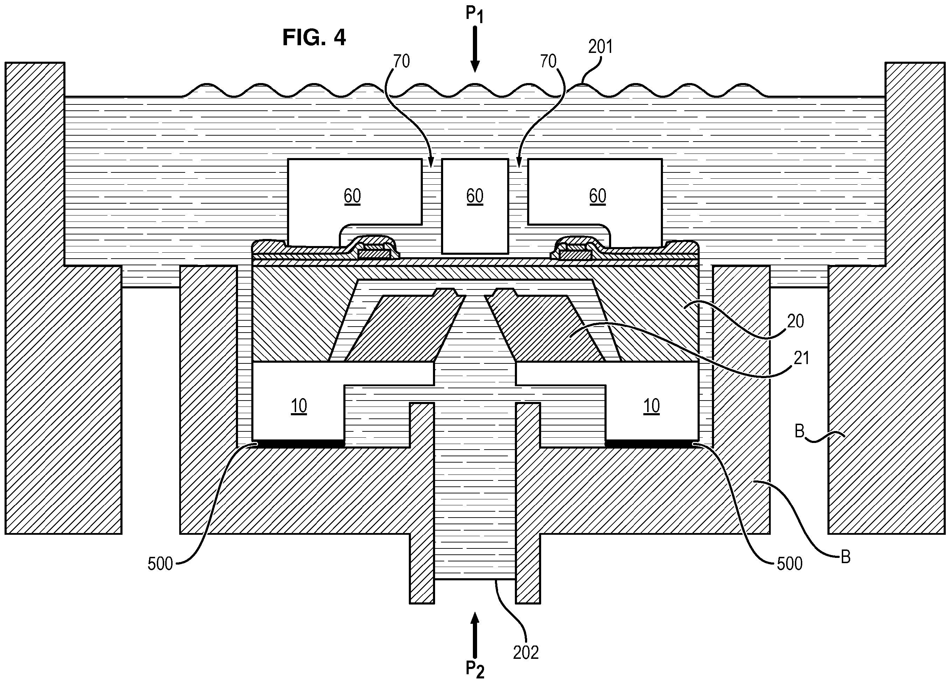

Pour améliorer, la résistance de la structure micromécanique pour la mesure différentielle de la pression celle-ci comprend en outre une butée supérieure 60 disposée au-dessus de la membrane 20 (voir les figures 2 et 4).

La butée supérieure 60 a la fonctionnalité de protéger mécaniquement la membrane 20 dans le cas où la surpression vient du dessous de la structure (pression P2 sur les figures 2 et 4).

La butée supérieure 60 présente en outre un ou plusieurs évidements 70 (typiquement quatre) en son centre et est connectée au reste de la structure via un scellement anodique ou au moyen d'une liaison moléculaire ou covalente avec ou sans couche intermédiaire, ou par frittage ou par brasage.

Les évidements 70 sont percés dans la butée supérieure 60 pour réduire les effets de capillarité et de dilatation en température après remplissage par le fluide, ainsi que pour faciliter la transmission de la pression P1. Des évidements sont réalisés aux quatre coins de la butée 60 supérieure pour permettre la connexion à un boitier mécanique.

En effet, comme cela est illustré sur la figure 4, la structure ci-dessus décrite est destinée à être placée dans un boitier B et sera noyée dans le fluide (zones en hachures quadrillées de la figure 4).

La butée supérieure 60 est, de préférence, obtenue à partir d'un substrat de verre borosilicate percé.

La butée supérieure 60 présente des zones de surgravure, au niveau des pistes métalliques ainsi qu'aux quatre coins de la butée supérieure, afin de permettre la connexion électrique et pour faciliter le remplissage par le fluide. De plus, comme précédemment, les zones épargnées par la surgravure sont protégées par un procédé de photolithographie 3D de type connu à base de résine épaisse.

## Revendications

1. Structure micromécanique destinée à mesurer ou à détecter une grandeur mécanique ou une grandeur dynamique, comprenant une membrane (20) déformable et un substrat support (10), la membrane (20) comprenant une première partie (20a) et une seconde partie (20b) fine entourée par la première partie (20a), la seconde partie (20b) présentant une épaisseur inférieure à l'épaisseur de la première partie (20a), la première partie (20a) de la membrane étant en contact avec le substrat support (10), la seconde partie (20b) de la membrane (20) étant suspendue au-dessus du substrat support (10) définissant ainsi un espace libre (30), ladite structure micromécanique comportant en outre une butée inférieure (21) adaptée pour limiter les déformations de la membrane (20), ladite butée inférieure (21) étant disposée au-dessus du substrat support (10) et s'étendant dans l'espace libre (30) à partir dudit substrat support (10) vers la seconde partie (20b) de la membrane (20), le substrat support (10) et la butée inférieure (21) comportant un évidement (40, 40') central traversant, **caractérisée en ce que** la butée inférieure (21) comporte des ilots (101-108) qui s'étendent dans l'espace libre (30) vers la seconde partie (20b) de la membrane (20) à partir d'une surface plane de la butée inférieure (21), les ilots (101-108) formant une structure en relief de sorte qu'en cas de contact entre les ilots (101-108) et la seconde partie fine (20b) de la membrane (20), la surface de contact entre les ilots (101-108) et la seconde partie fine (20b) de la membrane (20) soit faible par rapport aux dimensions de la partie fine (20b) de la membrane (20) et **en ce que** l'évidement (40') central traversant de la butée inférieure (21) est en forme de cône.

2. Structure micromécanique selon la revendication 1, dans laquelle les ilots (101-108) comportent des facettes inclinées qui sont orientées selon des angles aigus supérieurs à zéro degré par rapport à la surface plane de la butée inférieure (21).

3. Structure micromécanique selon l'une des revendications 1 à 2, dans laquelle les ilots sont en forme de mésa.

4. Structure micromécanique selon l'une des revendications précédentes, dans laquelle la partie fine (20b) de la membrane (20) présente une épaisseur comprise entre 20 µm et 100 µm.

5. Structure micromécanique selon l'une des revendications précédentes, dans laquelle les ilots sont dimensionnés de manière à ce que la partie fine de la membrane et les ilots soient espacés d'une distance comprise entre 5 et 30 µm, de préférence 10 µm.

6. Structure micromécanique selon l'une des revendications précédentes, dans laquelle les ilots (101-108) présentent une hauteur comprise entre 10 µm et 50 µm et une largeur maximale, à la base, comprise entre 20 µm et 200 µm.

7. Structure micromécanique selon l'une des revendications précédentes, comprenant en outre une butée supérieure (60) disposée au-dessus de la membrane.

8. Structure micromécanique selon la revendication précédente, dans laquelle la butée supérieure (60) comprend des évidements répartis autour de son centre.

9. Structure micromécanique selon l'une des revendications précédentes, dans laquelle la base support (10) et la butée inférieure (21) sont formées dans des matériaux différents.

10. Structure micromécanique selon la revendication précédente, dans laquelle le substrat support est en verre et dans laquelle la butée et ledit substrat support en verre sont connectés par scellement anodique ou au moyen d'une liaison moléculaire ou covalente avec ou sans couche intermédiaire, ou par frittage ou par brasage.

11. Structure micromécanique selon l'une des revendications 1 à 10, dans laquelle la base support et la butée inférieure (21) sont formées dans un seul et même matériau.

12. Structure micromécanique selon l'une des revendications précédentes, **caractérisée en ce que** la base support et la butée sont chacune en un matériau choisi parmi les matériaux suivants : verre ; quartz ; alumine ; céramique ; alliages ; Si ; SiC ; saphir.

13. Capteur de pression différentielle comprenant une structure micromécanique selon l'une des revendications précédentes.

## Patentansprüche

1. Mikromechanische Struktur, die dazu bestimmt ist, eine mechanische Größe oder eine dynamische Größe zu messen oder zu detektieren, umfassend eine verformbare Membran (20) und ein Trägersubstrat (10), wobei die Membran (20) einen ersten Abschnitt (20a) und einen zweiten feinen Abschnitt (20b) umfasst, der durch den ersten Abschnitt (20a) umgeben ist, wobei der zweite Abschnitt (20b) eine Stärke kleiner als die Stärke des ersten Abschnitts (20a) aufweist, wobei der erste Abschnitt (20a) der Membran in Kontakt mit dem Trägersubstrat (10) ist, wobei der zweite Abschnitt (20b) der Membran (20) über dem Trägersubstrat (10) hängend ist, und so einen Freiraum (30) definiert, wobei die mikromechanische Struktur weiter einen unteren Anschlag (21) beinhaltet, der angepasst ist, um die Verformungen der Membran (20) zu beschränken, wobei der untere Anschlag (21) über dem Trägersubstrat (10) angeordnet ist und sich in dem Freiraum (30) ausgehend von dem Trägersubstrat (10) zum zweiten Abschnitt (20b) der Membran (20) erstreckt, wobei das Trägersubstrat (10) und der untere Anschlag (21) eine zentrale querende Ausnehmung (40, 40') beinhalten,
**dadurch gekennzeichnet, dass** der untere Anschlag (21) Blöcke (101-108) beinhaltet, die sich in dem Freiraum (30) zum zweiten Abschnitt (20b) der Membran (20), ausgehend von einer ebenen Oberfläche des unteren Anschlags (21) erstrecken, wobei die Blöcke (101-108) eine solche Relief-Struktur bilden, dass bei einem Kontakt zwischen den Blöcken (101-108) und dem zweiten feinen Abschnitt (20b) der Membran (20), die Kontaktoberfläche zwischen den Blöcken (101-108) und dem zweiten feinen Abschnitt (20b) der Membran (20) im Verhältnis zu den Abmessungen des feinen Abschnitts (20b) der Membran (20) gering ist, und dadurch, dass die zentrale querende Ausnehmung (40') des unteren Anschlags (21) kegelförmig ist.

2. Mikromechanische Struktur nach Anspruch 1, wobei die Blöcke (101-108) geneigte Facetten beinhalten, die in spitzen Winkeln größer als Null Grad im Verhältnis zur ebenen Oberfläche des unteren Anschlags (21) ausgerichtet sind.

3. Mikromechanische Struktur nach einem der Ansprüche 1 bis 2, wobei die Blöcke mesaförmig sind.

4. Mikromechanische Struktur nach einem der vorstehenden Ansprüche, wobei der feine Abschnitt (20b) der Membran (20) eine Stärke zwischen 20 µm und 100 µm aufweist.

5. Mikromechanische Struktur nach einem der vorstehenden Ansprüche, wobei die Blöcke derart bemessen sind, dass der feine Abschnitt der Membran und die Blöcke um eine Distanz zwischen 5 und 30 µm, vorzugsweise 10 µm, beabstandet sind.

6. Mikromechanische Struktur nach einem der vorstehenden Ansprüche, wobei die Blöcke (101-108) eine Höhe zwischen 10 µm und 50 µm und eine maximale Breite, an der Basis, zwischen 20 µm und 200 µm aufweisen.

7. Mikromechanische Struktur nach einem der vorstehenden Ansprüche, weiter umfassend einen oberen Anschlag (60), der über der Membran angeordnet ist.

8. Mikromechanische Struktur nach dem vorstehenden Anspruch, wobei der obere Anschlag (60) Ausnehmungen umfasst, die um sein Zentrum verteilt sind.

9. Mikromechanische Struktur nach einem der vorstehenden Ansprüche, wobei die Trägerbasis (10) und der untere Anschlag (21) aus unterschiedlichen Materialien gebildet sind.

10. Mikromechanische Struktur nach dem vorstehenden Anspruch, wobei das Trägersubstrat aus Glas ist und wobei der Anschlag und das Trägersubstrat aus Glas durch anodisches Versiegeln oder anhand einer molekularen oder kovalenten Verbindung mit oder ohne Zwischenschicht, oder durch Sintern oder durch Löten verbunden sind.

11. Mikromechanische Struktur nach einem der Ansprüche 1 bis 10, wobei die Trägerbasis und der untere Anschlag (21) aus ein und demselben Material gebildet sind.

12. Mikromechanische Struktur nach einem der vorstehenden Ansprüche, **dadurch gekennzeichnet, dass** die Trägerbasis und der Anschlag jeweils aus einem Material sind, das aus den folgenden Materialien ausgewählt ist: Glas; Quarz; Aluminiumoxid; Keramik; Legierungen; Si; SiC; Saphir.

13. Differenzdrucksensor, umfassend eine mikromechanische Struktur nach einem der vorstehenden Ansprüche.

## Claims

1. Micromechanical structure intended to measure or to detect a mechanical value or a dynamic value, comprising a deformable membrane (20) and a supporting substrate (10), the membrane (20) comprising a first portion (20a) and a second fine portion (20b) surrounded by the first portion (20a), the second portion (20b) having a thickness less than the thickness of the first portion (20a), the first portion (20a) of the membrane being in contact with the supporting substrate (10), the second portion (20b) of the membrane (20) being suspended above the supporting substrate (10) thus defining a free space (30), said micromechanical structure further comprising a lower stop (21) adapted for limiting the deformations of the membrane (20), said lower stop (21) being disposed above the supporting substrate (10) and extending in the free space (30) from said supporting substrate (10) towards the second portion (20b) of the membrane (20), the supporting substrate (10) and the lower stop (21) comprising a central through hole (40, 40'), **characterised in that** the lower stop (21) comprises islets (101-108) that extend in the free space (30) towards the second portion (20b) of the membrane (20) from a flat surface of the lower stop (21), the islets (101-108) forming a structure in relief in such a way that in the case of contact between the islets (101-108) and the second fine portion (20b) of the membrane (20), the surface of contact between the islets (101-108) and the second fine portion (20b) of the membrane (20) is small with respect to the dimensions of the fine portion (20b) of the membrane (20) and **in that** the central through-hole (40') of the lower stop (21) is in the shape of a cone.

2. Micromechanical structure according to claim 1, wherein the islets (101-108) comprise inclined facets that are oriented according to acute angles greater than zero degrees with respect to the flat surface of the lower stop (21).

3. Micromechanical structure according to one of claims 1 to 2, wherein the islets are in the shape of a mesa.

4. Micromechanical structure according to one of the previous claims, wherein the fine portion (20b) of the membrane (20) has a thickness between 20µm and 100µm.

5. Micromechanical structure according to one of the previous claims, wherein the islets are dimensioned in such a way that the fine portion of the membrane and the islets are spaced apart by a distance between 5 and 30µm, preferably 10µm.

6. Micromechanical structure according to one of the previous claims, wherein the islets (101-108) have a height between 10µm and 50µm and a maximum width, at the base, between 20µm and 200µm.

7. Micromechanical structure according to one of the previous claims, further comprising an upper stop (60) disposed above the membrane.

8. Micromechanical structure according to the previous claim, wherein the upper stop (60) comprises recesses distributed around its centre.

9. Micromechanical structure according to one of the previous claims, wherein the supporting base (10) and the lower stop (21) are formed from different materials.

10. Micromechanical structure according to the previous claim, wherein the supporting substrate is made of glass and wherein the stop and said supporting substrate made of glass are connected by anode sealing or by means of a molecular or covalent bond with or without an intermediate layer, or by sintering or by brasing.

11. Micromechanical structure according to one of claims 1 to 10, wherein the supporting base and the lower stop (21) are formed from the same single material.

12. Micromechanical structure according to one of the previous claims, **characterised in that** the supporting base and the stop are each made of a material chosen from the following materials: glass; quartz; alumina; ceramic; alloys; Si; SiC; sapphire.

13. Differential pressure sensor comprising a micromechanical structure according to one of the previous claims.
